# EUROPÄISCHE PATENTSCHRIFT

(11) **EP 1 338 182 B1**
(45) Veröffentlichungstag und Bekanntmachung des Hinweises auf die Patenterteilung: **27.06.2007**
(21) Anmeldenummer: 01982246.9
(22) Anmeldetag: 05.09.2001
(51) Int. Cl.: H05K 1/18

(54) **ELEKTRISCHES BAUELEMENT, ANORDNUNG DES BAUELEMENTS UND VERFAHREN ZUR HERSTELLUNG DER ANORDNUNG**
ELECTRICAL COMPONENT, ARRANGEMENT FOR SAID COMPONENT AND METHOD FOR PRODUCING SAID ARRANGEMENT
COMPOSANT ELECTRIQUE, AGENCEMENT DUDIT ELEMENT ET PROCEDE POUR REALISER CET AGENCEMENT

(30) Priorität: 30.11.2000 DE 10059534
(43) Veröffentlichungstag der Anmeldung: 27.08.2003
(73) Patentinhaber: EPCOS AG, 81669 München (DE)
(72) Erfinder: BOY, Jürgen, 13465 Berlin (DE); RUND, Klaus, 12109 Berlin (DE); BOTHE, Frank, 12555 Berlin (DE)
(74) Vertreter: Epping - Hermann - Fischer
(86) Internationale Anmeldenummer: PCT/EP2001/010234
(87) Internationale Veröffentlichungsnummer: WO 2002/045469

(56) Entgegenhaltungen:
- WO-A-97/25843
- WO-A-97/49151
- DE-A- 2 731 998
- US-A- 4 695 927
- US-A- 5 786 745
- PATENT ABSTRACTS OF JAPAN vol. 016, no. 097 (E-1176), 10. März 1992 (1992-03-10) -& JP 03 277007 A (MURATA MFG CO LTD), 9. Dezember 1991 (1991-12-09)

## Beschreibung

Die Erfindung betrifft ein elektrisches Bauelement mit einem Grundkörper, der zwei Isolierkörper mit gekrümmten Außenflächen umfaßt und an dessen Stirnflächen je eine Außenelektrode angeordnet ist. Ferner ist in einem Mittelabschnitt des Grundkörpers entlang seiner Mantelfläche eine Mittelelektrode angeordnet.

Es sind Bauelemente der eingangs genannten Art bekannt, die als Überspannungsableiter oder auch als Schaltfunkenstrecken verwendet werden. Um diese Bauelemente in Oberflächenmontagetechnik auf Leiterplatten auflöten zu können, ist es erforderlich, daß die Bauelemente lagerichtig in den Taschen eines Transportgurts und auch auf der Leiterplatte plaziert werden können. Ein Wegrollen des Bauelementes auf der Leiterplatte oder in den Gurttaschen ist nicht erwünscht. Weiterhin sollen die Anschlußflächen des Bauelements groß genug für eine zuverlässige Lötung sein.

Zur Vermeidung des Wegrollens ist es aus der Druckschrift WO 97/25843 bekannt, die Außenelektroden beziehungsweise die Mittelelektrode des Bauelements mit fußartig geformten Anschlußdrähten zu versehen. Diese Anschlußdrähte sind speziell geformt und werden an das Bauelement geschweißt, geklemmt oder gelötet, um eine mechanisch feste und elektrisch leitende Verbindung herzustellen.

Aufgrund der zusätzlich angelöteten Anschlußdrähte haben die bekannten Bauelemente den Nachteil eines erhöhten Platzbedarfs. Die Anschlußdrähte sind nämlich seitlich vom Bauelement weg gebogen. Darüber hinaus haben die bekannten Bauelemente den Nachteil, daß für die Herstellung, Formung und Anbringung der Anschlußdrähte zusätzliche Kosten entstehen.

Zudem haben die bekannten Bauelemente den Nachteil, daß die Anschlußdrähte eine beträchtliche Wärmekapazität aufweisen, die beim gleichzeitigen Verlöten mit anderen, kleineren Bauelementen, die gewöhnlich eine sehr geringe Wärmekapazität aufweisen, zu Problemen führt. Es muß nämlich beim Lötvorgang eine bestimmte, für das Aufschmelzen des Lotes ausreichende Wärme zur Verfügung gestellt werden. Sind nun Bauelemente mit großer Wärmekapazität festzulöten, so wird auch entsprechend eine erhöhte Wärmemenge vom Lötbad an die Leiterplatte beziehungsweise die Bauelemente abgegeben. Diese erhöhte Wärmemenge kann kleinere Bauelemente leicht zerstören.

Ziel der vorliegenden Erfindung ist es daher, ein Bauelement der eingangs genannten Art anzugeben, bei dem das Wegrollen von einer Leiterplatte erschwert ist und das einen geringen Platzbedarf aufweist.

Dieses Ziel wird erfindungsgemäß durch ein Bauelement nach Patentanspruch 1 erreicht. Vorteilhafte Ausgestaltungen der Erfindung, eine Anordnung des Bauelements sowie ein Verfahren zur Herstellung der Anordnung sind den weiteren Ansprüchen zu entnehmen.

Die Erfindung gibt ein elektrisches Bauelement an, das einen Grundkörper umfaßt, welcher zwei Isolierkörper mit gekrümmten Außenflächen aufweist. An den Stirnflächen des Grundkörpers ist je eine Außenelektrode angeordnet. In einem Mittelabschnitt des Grundkörpers ist entlang seiner Mantelfläche eine Mittelelektrode angeordnet. Diese Mittelelektrode weist an der Außenseite des Bauelements eine ebene Montagefläche auf, die wenigstens teilweise aus der Außenkontur des Bauelements hervorsteht.

Zur einfacheren Herstellung können die Isolierkörper ebenso wie die Außenelektroden zylindersymmetrisch ausgebildet sein.

Das erfindungsgemäße Bauelement hat den Vorteil, daß durch die ebene Montagefläche der Mittelelektrode eine vergrößerte Lötfläche bereitsteht, mit der Möglichkeit einer besseren Lötbefestigung auf einer Leiterplatte.

Ferner wird durch die ebene Montagefläche das Wegrollen des Bauelements mit den gekrümmten Außenflächen auf einer Leiterplatte verhindert.

Es kann also bei dem erfindungsgemäßen Bauelement auf zusätzliche Anschlußdrähte verzichtet werden, wodurch das Bauelement sich durch einen verringerten Platzbedarf auszeichnet, welcher sich bei der Höchstintegration von Bauelementen in elektrischen Modulen als Vorteil erweist. Weiterhin können durch den Verzicht auf Anschlußdrähte die Herstellungskosten für das Bauelement sowie dessen Wärmekapazität gesenkt werden.

In einer besonders vorteilhaften Ausführungsform der Erfindung weist die Mittelelektrode des Bauelements eine ebene Haltefläche auf, die der Montagefläche gegenüberliegend angeordnet ist. Durch diese ebene Haltefläche kann das Bauelement mit einer Ansaugdüse festgehalten werden und ist somit für die Verwendung in Bestückautomaten, die nach dem Pick-and-Place-Prinzip arbeiten, geeignet.

Weiterhin ist es vorteilhaft, wenn die Mittelelektrode eine zwischen den Isolierkörpern angeordnete Scheibe ist. Eine solche Ausführungsform der Erfindung entspricht dem Aufbau eines 3-Elektroden-Ableiters, bei dem der mittlere Außenkontakt und die Innenelektrode des Ableiters einstückig in die Mittelelektrode integriert sind.

Für die Gestaltung der Mittelelektrode gibt es verschiedene Ausführungsformen; beispielsweise kann die Mittelelektrode im Querschnitt die Form eines Quadrats, eines Sechsecks oder auch eines Achtecks aufweisen. Darüber hinaus besteht die Möglichkeit, daß die Mittelelektrode im Querschnitt die Form eines Quadrats mit abgerundeten Ecken oder die Form eines Kreises mit zwei gegenüberliegenden Abflachungen aufweist. Je nach Herstellungsverfahren für die Mittelelektrode kann aus den angegebenen Ausführungsformen die am besten geeignete ausgesucht werden.

Mögliche Herstellungsverfahren für die Mittelelektrode sind beispielsweise Kaltfließpressen, Stanzen oder auch Drehen der Mittelelektrode aus von einer Halbzeugstange abgeschnittenen Scheiben. Zu beachten ist dabei, daß bei gängigen 3-Elektroden-Ableitern die Mittelelektroden nicht die Form einer flachen Scheibe, sondern die Form einer profilierten Scheibe haben, wobei zur Mitte der Scheibe hin Vorsprünge vorgesehen sind.

Zur Verwendung des erfindungsgemäßen Bauelements als 3-Elektroden-Ableiter kann vorteilhaft im Innern des Grundkörpers ein Hohlraum angeordnet sein, der mit einem Gas gefüllt ist.

Die Erfindung gibt ferner eine Anordnung des erfindungsgemäßen Bauelements an, bei der die Montagefläche der Mittelelektrode mit der Oberfläche einer Leiterplatte verlötet ist. Aufgrund der vorteilhaften Gestaltung des Bauelements hat die Anordnung den Vorteil, daß sie leicht herstellbar ist, da das Bauelement sich nicht so leicht von einer einmal festgelegten Position auf der Leiterplatte durch Wegrollen entfernt.

Darüber hinaus gibt die Erfindung ein Verfahren zur Herstellung der Anordnung an. Das Verfahren umfaßt folgende Schritte:
a) Ansaugen des Bauelements an der Haltefläche der Mittelelektrode mit Hilfe einer Ansaugdüse
b) Positionieren des Bauelements mit Hilfe der Ansaugdüse so auf der Leiterplatte, daß das Bauelement mit der Montagefläche auf der Oberfläche der Leiterplatte aufliegt
c) Festlöten des Bauelements.

Dieses Verfahren hat den Vorteil, daß es für den Einsatz in Pick-and-Place-Automaten oder auch in anderen Bestückungsautomaten geeignet ist. Somit kann in kurzer Zeit eine große Anzahl von Leiterplatten mit dem Bauelement bestückt werden.

Desweiteren ist das Bauelement aufgrund seiner ebenen Haltebeziehungsweise Montagefläche auch zum Transport in Taschen von Bauelementgurten geeignet. Durch die ebenen Flächen rollt das Bauelement nicht so leicht innerhalb der Tasche, die gewöhnlich einen ebenen Boden aufweist, weg, wodurch sich leicht eine definierte Position, zum Beispiel Haltefläche nach oben, einstellen und auch beibehalten läßt.

Im folgenden wird die Erfindung anhand von Ausführungsbeispielen und den dazu gehörigen Figuren näher erläutert.
- Figur 1: zeigt beispielhaft ein erfindungsgemäßes Bauelement in einer schematischen Seitenansicht.
- Figur 2: zeigt das Bauelement aus Figur 1 in einer weiteren Seitenansicht.
- Die Figuren 3A bis 3E: zeigen beispielhaft verschiedene Ausführungsformen der für die Verwendung in der Erfindung geeigneten Mittelelektrode in jeweils einer Draufsicht und in einer Seitenansicht.
- Figur 4: zeigt beispielhaft die erfindungsgemäße Anordnung des Bauelements in einer Seitenansicht.

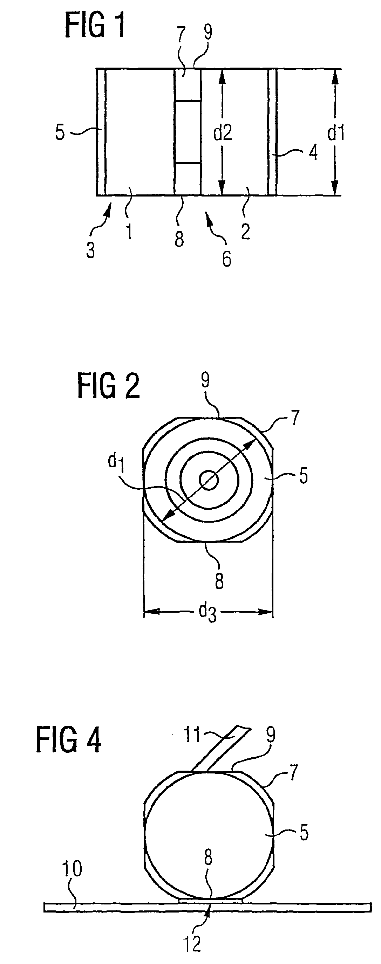

Figur 1 zeigt ein erfindungsgemäßes Bauelement mit einem Grundkörper 3, der zwei Isolierkörper 1 und 2 umfaßt. Die Isolierkörper 1, 2 sind Keramikhülsen in zylindersymmetrischer Ausführung. Die Keramikhülsen sind gasdicht mittels Hartlot mit einer Mittelelektrode 7 aus Metall, vorzugsweise Kupfer, verlötet. Die Mittelelektrode 7 ist in einem Mittelabschnitt 6 des Grundkörpers 3 angeordnet.

Durch die gasdichte Verlötung ist es möglich, im Innern des Grundkörpers 3 einen gasdichten Hohlraum anzuordnen. Die Mittelelektrode 7 weist eine Montagefläche 8 und eine Haltefläche 9 auf. Beide Flächen 8, 9 sind eben. An den Stirnseiten des Grundkörpers 3 sind Außenelektroden 4 und 5 angebracht.

In der speziellen in Figur 1 gezeigten Ausführungsform sind die Außenelektroden 4, 5 ebenso wie die Isolierkörper 1, 2 zylindersymmetrisch ausgeführt und der Durchmesser d₁ der Außenelektroden 4, 5 ist genauso groß wie der Durchmesser d₂ der Isolierkörper 1, 2. Es ist jedoch auch eine weitere Ausführungsform der Erfindung denkbar, bei der der Durchmesser d₁ der Außenelektroden 4, 5 größer ist als der Durchmesser d₂ der Isolierkörper 1, 2. Bezüglich der Lötbarkeit des Bauelements auf eine Leiterplatte hätte eine solche weitere Ausführungsform keine Nachteile.

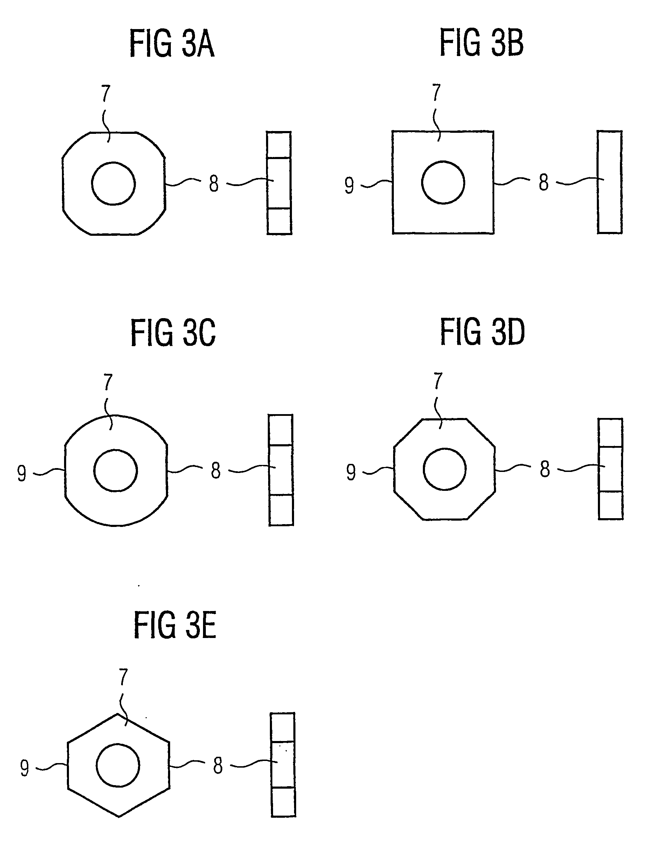

Figur 2 zeigt das Bauelement aus Figur 1 in einer Seitenansicht. Die Bezugszeichen in Figur 2 entsprechen denen in Figur 1. Die Mittelelektrode 7 hat im Querschnitt eine Form, wie sie auch in Figur 3A dargestellt ist. Zusätzlich zu der Montagefläche 8 und der Haltefläche 9 weist die Mittelelektrode 7 noch zwei weitere seitliche ebene Flächen auf. Der kleinste Durchmesser d₃ der Mittelelektrode 7 ist genauso groß wie der Durchmesser d₂ der Isolierkörper 1, 2 beziehungsweise der Durchmesser d₁ der Außenelektroden 4, 5. Dadurch ist gewährleistet, daß die Montagefläche 8 über ihre ganze Fläche aus dem Umriß des Bauelements hervorragt und dadurch ihre Funktion als Lagestabilisator optimal erfüllen kann. Es ist aber auch möglich, daß der kleinste Durchmesser d₃ der Mittelelektrode 7 größer ist als der Durchmesser d₁ der Außenelektroden 4, 5.

Die in Figur 2 gezeigten inneren Kreise der Außenelektrode 5 deuten eine kalottenartige Vertiefung beziehungsweise einen darin angeordneten Anschlußbutzen an, die für die Erfindung jedoch ohne Belang sind.

Die Figuren 3A bis 3E zeigen verschiedene Ausführungsformen für die Mittelelektrode 7 in Draufsicht und in Seitenansicht. Es ist jeweils die Montagefläche 8 beziehungsweise die Haltefläche 9 dargestellt. Das jeweils in der Mitte der Mittelelektrode 7 gezeigte Loch wird für den gasgefüllten Hohlraum im Innern des Grundkörpers des Bauelements benötigt.

Figur 3A zeigt eine Mittelelektrode 7 in Form eines Quadrats mit abgerundeten Ecken, Figur 3B in Form eines ganzen Quadrates, Figur 3C in Form eines Kreises mit zwei gegenüberliegenden Abflachungen, Figur 3D in Form eines Achtecks und Figur 3E in Form eines Sechsecks.

Figur 4 zeigt eine erfindungsgemäße Anordnung des Bauelements, wobei die Bezugszeichen in Figur 4 denen in Figur 2 entsprechen. Mit der Montagefläche 8 liegt das Bauelement auf der Oberfläche einer Leiterplatte 10 auf. Mittels Lot 12 ist das Bauelement mit der Leiterplatte 10 verlötet. Das Positionieren des Bauelements auf der Leiterplatte 10 kann beispielsweise mittels einer Ansaugdüse 11 durchgeführt werden, welche das Bauelement an der oberen Haltefläche 9 ansaugt.

Die Erfindung beschränkt sich nicht auf die dargestellten Ausführungsbeispiele, sondern wird in ihrer allgemeinsten Form durch Patentanspruch 1 definiert.

## Patentansprüche

1. Elektrisches Bauelement
- mit einem Grundkörper (3), der zwei Isolierkörper (1, 2) mit gekrümmten Außenflächen umfaßt und an dessen Stirnflächen je eine Außenelektrode (4, 5) angeordnet ist,
- bei dem in einem Mittelabschnitt (6) des Grundkörpers entlang seiner Mantelfläche eine Mittelelektrode (7) angeordnet ist,
- und bei dem die Mittelelektrode (7) an der Außenseite des Bauelements eine ebene Montagefläche (8) aufweist die wenigstens teilweise aus der Aussenkontur des Bauelements hervorsteht.

2. Bauelement nach Anspruch 1,
bei dem die Isolierkörper (1, 2) und die Außenelektroden (4, 5) zylindersymmetrisch ausgebildet sind.

3. Bauelement nach Anspruch 1 oder 2,
bei dem die Mittelelektrode (7) eine der Montagefläche (8) gegenüberliegende ebene Haltefläche (9) aufweist.

4. Bauelement nach Anspruch 1 bis 3,
bei dem die Mittelelektrode (7) eine zwischen den Isolierkörpern (1, 2) angeordnete Scheibe ist.

5. Bauelement nach Anspruch 4,
bei dem die Mittelelektrode (7) im Querschnitt die Form eines Quadrats, Sechsecks oder Achtecks aufweist.

6. Bauelement nach Anspruch 4,
bei dem die Mittelelektrode (7) im Querschnitt die Form eines Quadrats mit abgerundeten Ecken aufweist.

7. Bauelement nach Anspruch 4,
bei dem die Mittelelektrode (7) im Querschnitt die Form eines Kreises mit zwei gegenüberliegenden Abflachungen aufweist.

8. Bauelement nach Anspruch 1 bis 7,
bei dem die Außenelektroden (4, 5) einen kreisförmigen Querschnitt aufweist.

9. Bauelement nach Anspruch 8,
bei dem der Durchmesser (d₁) der Außenelektroden (4, 5) genauso groß ist wie der Durchmesser (d₂) der Isolierkörper (1, 2).

10. Bauelement nach Anspruch 8,
bei dem der Durchmesser (d₁) der Außenelektroden (4, 5) größer ist als der Durchmesser (d₂) der Isolierkörper (1, 2).

11. Bauelement nach Anspruch 8,
bei dem der kleinste Durchmesser (d₃) der Mittelelektrode (7) wenigstens genauso groß ist wie der Durchmesser (d₁) der Außenelektroden (4, 5).

12. Bauelement nach Anspruch 1 bis 11,
das einen im Innern des Grundkörpers (3) angeordneten gasgefüllten Hohlraum aufweist.

13. Anordnung eines Bauelements nach Anspruch 1 bis 12,
bei der die Montagefläche (8) der Mittelelektrode (7) mit der Oberfläche einer Leiterplatte (10) verlötet ist.

14. Verfahren zur Herstellung einer Anordnung nach Anspruch 13 mit folgenden Schritten:
a) Ansaugen des Bauelements an der Haltefläche (9) der Mittelelektrode (7) mit Hilfe einer Ansaugdüse (11)
b) Positionieren des Bauelements mit Hilfe der Ansaugdüse (11) so auf die Leiterplatte (10), daß das Bauelement mit der Montagefläche (8) auf der Oberfläche der Leiterplatte (10) aufliegt
c) Festlöten des Bauelements.

## Claims

1. Electrical component
- comprising a base body (3), which includes two insulating bodies (1, 2) with curved outer surfaces, and on each end surface of which is arranged an outer electrode (4, 5),
- in which a central electrode (7) is arranged in a central section (6) of the base body along the surface of its case,
- and in which, on the outside of the component, the central electrode (7) has a flat mounting surface (8), which protrudes at least partially from the outer contour of the component.

2. Component according to Claim 1, in which the insulating bodies (1, 2) and the outer electrodes (4, 5) are formed as symmetrical cylinders.

3. Component according to Claim 1 or 2, in which the central electrode (7) has a flat holding surface (9), which is opposite the mounting surface (8).

4. Component according to Claim 1 to 3, in which the central electrode (7) is a disc arranged between the insulating bodies (1, 2).

5. Component according to Claim 4, in which the central electrode (7) has a cross-section in the form of a square, a hexagon or an octagon.

6. Component according to Claim 4, in which the central electrode (7) has a cross-section in the form of a square with rounded corners.

7. Component according to Claim 4, in which the central electrode (7) has a cross-section in the form of a circle with two opposite flats.

8. Component according to Claim 1 to 7, in which the outer electrodes (4, 5) have a circular cross-section.

9. Component according to Claim 8, in which the diameter (d₁) of the outer electrodes (4, 5) is exactly the same as the diameter (d₂) of the insulating bodies (1, 2).

10. Component according to Claim 8, in which the diameter (d₁) of the outer electrodes (4, 5) is greater than the diameter (d₂) of the insulating bodies (1, 2).

11. Component according to Claim 8, in which the smallest diameter (d₃) of the central electrode (7) is at least as large as the diameter (d₁) of the outer electrodes (4, 5).

12. Component according to Claim 1 to 11, which has a gas-filled hollow space arranged inside the base body (3).

13. Arrangement of a component according to Claim 1 to 12, in which the mounting surface (8) of the central electrode (7) is soldered to the surface of a printed circuit board (10).

14. Method for manufacturing an arrangement according to Claim 13 with the following steps:
a) Picking up the component by the holding surface (9) of the central electrode (7) with the help of a suction nozzle (11)
b) Positioning the component on the printed circuit board (10) with the help of the suction nozzle (11) so that the mounting surface (8) of the component rests on the surface of the printed circuit board (10)
c) Soldering the component firmly in place.

## Revendications

1. Composant électrique
- ayant une pièce (3) de base, qui comprend deux pièces (1, 2) isolantes ayant des surfaces extérieures courbées et sur les faces frontales desquelles est disposé respectivement une électrode (4, 5) extérieure,
- dans lequel il est disposé, dans une partie (6) médiane de la pièce de base, le long de sa surface latérale, une électrode (7) médiane,
- et dans lequel l'électrode (7) médiane a, sur le côté extérieur du composant, une surface (8) plane de montage, qui fait saillie au moins en partie du contour extérieur du composant.

2. Composant suivant la revendication 1,
dans lequel la pièce (1, 2) isolante et les électrodes (4, 5) extérieures sont cylindrosymétriques.

3. Composant suivant la revendication 1 ou 2,
dans lequel l'électrode (7) médiane a une surface (9) plane de maintien opposée à la surface (8) de montage.

4. Composant suivant la revendication 1 à 3,
dans lequel l'électrode (7) médiane est un disque disposé entre les pièces (1, 2) isolantes.

5. Composant suivant la revendication 4,
dans lequel l'électrode (7) médiane a une section transversale en forme de carré, d'hexagone ou d'octogone.

6. Composant suivant la revendication 4,
dans lequel l'électrode (7) médiane a, en section transversale, la forme d'un carré à sommets arrondis.

7. Composant suivant la revendication 4,
dans lequel l'électrode (7) médiane a, en section transversale, la forme d'un cercle ayant deux méplats opposés.

8. Composant suivant la revendication 1 à 7,
dans lequel les électrodes (4, 5) extérieures ont une section transversale circulaire.

9. Composant suivant la revendication 8,
dans lequel le diamètre (d₁) des électrodes (4, 5) extérieures est exactement aussi grand que le diamètre (d₂) des pièces (1, 2) isolantes.

10. Composant suivant la revendication 8,
dans lequel le diamètre (d₁) des électrodes (4, 5) extérieures est plus grand que le diamètre (d₂) des pièces (1, 2) isolantes.

11. Composant suivant la revendication 8,
dans lequel le diamètre (d₃) le plus petit de l'électrode (7) médiane est au moins exactement aussi grand que le diamètre (d₁) des électrodes (4, 5) extérieures).

12. Composant suivant la revendication 1 à 11,
qui a une cavité emplie de gaz à l'intérieur de la pièce (3) de base.

13. Agencement d'un composant suivant la revendication 1 à 12,
dans lequel la surface (8) de montage de l'électrode (7) médiane est brasée à la surface d'une plaquette (10) à circuit imprimé.

14. Procédé de production d'un agencement suivant la revendication 13, comprenant les stades suivants dans lesquels :
a) on aspire le composant sur la surface (9) de maintien de l'électrode (7) médiane à l'aide d'une buse (11) d'aspiration,
b) on met le composant à l'aide de la buse (11) d'aspiration en position sur la plaquette (10) à circuit imprimé, de façon à ce que le composant s'applique par la surface (8) de montage à la surface de la plaquette (10) à circuit imprimé,
c) on brase le composant.
